# EUROPEAN PATENT APPLICATION

(11) **EP 4 220 688 A2**
(43) Date of publication of application: **02.08.2023**
(21) Application number: 23153665.7
(22) Date of filing: 27.01.2023
(51) Int. Cl.: H01L 21/306, H01L 29/51, H01L 29/06

(54) **A SEMICONDUCTOR LAYERED STRUCTURE**

(30) Priority: 31.01.2022 GB 202201241
(71) Applicant: IQE plc, Cardiff CF3 0LW (GB)
(72) Inventor: Hammond, Richard, Cardiff, CF3 0LW (GB); Andrew, Clark, Cardiff, CF3 0LW (GB); Pelzel, Rodney, Cardiff, CF3 0LW (GB)
(74) Representative: IQE plc

(57) **Abstract**

A method of fabricating a layered structure comprising growing an epitaxial layer on a substrate with a first resistivity proximal to the substrate and a second resistivity (less than the first) distal therefrom. Porosify the epitaxial layer to form a porous layer with porosity >30% proximal to the substrate and ≤25% distal from the substrate. Epitaxially grow a semiconductor (channel) layer over the porous layer. Also a layered structure comprising: a substrate; a porous layer; and an epitaxial semiconductor (channel) layer. The porous layer has a first porosity >30% proximal to the substrate and a second porosity ≤25% adjacent to the semiconductor layer. The two different porosities can be optimised for different functions. The higher porosity is effective at insulating the channel from the substrate. The lower porosity provides a crystalline structure with single crystal orientation exposed that supports the channel layer comprising high quality, low defect, epitaxial growth.

## Description

A layered structure, particularly but not exclusively for a radio frequency (RF) switch.

It is known from US2021/020,436 to provide a layered structure including a porous layer which is fully depleted of charge carriers. The substrate (starting material) is porosified to remove all charge carriers and therefore raise the resistivity of the resultant porous layer to over 10,000 ohm-centimetres (Ωcm). An advantage of the high porosity layer is that it is a very good electrical insulator and is therefore suitable for high frequency switching applications. One disadvantage of this structure is that the high resultant porosity exposes different crystal orientations on the inner surfaces of the pores so that it is difficult to grow a high quality, low defect, single crystal layer over the porous layer.

The present invention provides a layered structure comprising: a substrate; a porous layer; and an epitaxial semiconductor layer; wherein the porous layer has a first porosity greater than 30% proximal to the substrate and a second porosity less than or equal to 25% adjacent to the semiconductor layer.

The porous layer having two different porosities is advantageous because each porosity can be optimised for different functions. The higher porosity proximal to the substrate is effective at insulating the semiconductor from the substrate (harmonic performance). The lower porosity adjacent to the semiconductor layer provides a crystalline structure with single crystal orientation exposed that supports the semiconductor layer comprising high quality, low defect, epitaxial growth.

Advantageously the lower porosity portion is also a good thermal conductor, since more of the volume is filled with material and not air (or another fluid) in the pores. Thus the layered structure is able to transport the additional heat generated in the channel layer by high frequency switching better than prior layered structures.

The substrate may comprise silicon. Advantageously silicon based semiconductors are well established.

The substrate may have crystal orientation <100>, <110> or <111>. Alternatively the substrate may be in a first crystal orientation miscut towards a second crystal orientation by up to 20°. For example it may be <100> miscut towards the <111> orientation by 5°, 6°, 10°, 15°, or up to 20°. Advantageously the layered structure does not depend on a particular crystal orientation for the substrate meaning the orientation can be selected to suit the intended application.

The substrate may have a resistivity between 0.01Ωcm and 10Ωcm. Advantageously this is a common range of resistivity and so such a substrate can be processed in conventional foundries to produce the layered structure or subsequently to process the layered structure into devices.

The porous layer may comprise a group IV material or a compound of group IV elements. Advantageously such materials are compatible with a silicon substrate meaning that little or no strain is introduced between the substrate and porous layer due to lattice mismatch.

The porous layer may comprise silicon, germanium, carbon, silicon germanium, or silicon germanium tin. Advantageously the porous layer can be matched to the substrate and/or semiconductor layer. Alternatively, the porous layer may comprise a different material or compound to the semiconductor layer so that a small strain is introduced which improves carrier mobility.

The porous layer may be doped. The doping may have a graded profile through the porous layer from the substrate to the semiconductor layer. Advantageously a graded doping profile offers the benefits of the two different porosities whilst having no sharp interface which may introduce an undesirable spike in the band structure which may give undesirable device harmonic characteristics. Grading smooths the band structure thereby avoiding such discontinuities. Alternatively the porous layer may be doped with a first level of doping proximal to the substrate and a second level of doping adjacent to the semiconductor layer. Advantageously the properties of the two regions can be accurately controlled by the two doping levels.

The porous layer may have a resistivity greater than or equal to 3000Ωcm. Advantageously such resistivity range results in second harmonics less than -100dBm with 15dBm input power.

The semiconductor layer may comprise a group IV material, a compound of group IV elements, a compound of group III and group V elements, or a compound of one or more rare earth elements with group III and group V elements. Advantageously, this allows the optimal channel layer to be chosen to meet the specific device performance required. The semiconductor layer may comprise silicon, germanium, silicon germanium, silicon germanium tin, a III-N compound, gallium nitride, or a rare earth-III-N alloy. Advantageously the material can be the same as the porous layer. For example, the substrate, porous layer and semiconductor layer may all comprise silicon which forms a mono-elemental structure. Alternatively the material can be different to the porous layer. Advantageously a defined level of strain can be introduced which improves the carrier transport through the semiconductor layer, for example when the layered structure is implemented in an RF switch.

The semiconductor layer may have an RMS surface roughness of less than 1nm. Advantageously such a surface is very smooth meaning that excellent device characteristics, such as high carrier mobility, are possible.

The semiconductor layer may have a resistivity greater than or equal to 10Ωcm. Advantageously this results in good carrier transport (device harmonic performance).

The semiconductor layer may comprise a channel layer and the layered structure may further comprise a source, a drain and a gate. Such a structure forms a field effect transistor (FET). Advantageously the layered structure is suitable for processing into a switch, for example a radio frequency switch operating at mobile communications frequencies. For example, it may operate in the range 800MHz to 6GHz or higher.

The present invention also provides a method of fabricating a layered structure comprising steps to: grow an epitaxial layer on a substrate, wherein the epitaxial layer has a first resistivity proximal to the substrate and a second resistivity distal from the substrate, and wherein the second resistivity is less than the first resistivity; porosify the epitaxial layer to form a porous layer with porosity greater than 30% proximal to the substrate and porosity less than or equal to 25% distal from the substrate; and epitaxially grow a semiconductor layer over the porous layer.

Advantageously the resulting layered structure has two regions with different porosity which exhibit different properties. Advantageously the method is simpler than known methods of fabricating a semiconductor over an insulator which require fabrication and bonding of two sections. Advantageously the regions of higher and lower porosity can be optimised for thermal and harmonic performance by setting the resistivity of the epitaxial layer during the growth step.

The method may further comprise doping the epitaxial layer during the step to grow the epitaxial layer. Advantageously levels of doping can be precisely controlled and varied during the growth step to set the first resistivity proximal to the substrate and the second resistivity distal therefrom, adjacent to the surface on which the semiconductor layer is subsequently grown.

The doping may comprise doping the epitaxial layer with a lower level of dopant proximal to the substrate than adjacent to the semiconductor layer. Advantageously this results in a higher resistivity proximal to the substrate than adjacent to the semiconductor layer since resistivity is inversely proportional to doping concentration.

The method may further comprise a step to ion implant at least part of the epitaxial layer prior to the step to porosify the epitaxial layer. The ion implantation may be additional or alternative to the doping of the epitaxial layer during growth. The ion implantation may decrease the resistivity of the implanted portion of the epitaxial layer. Thus it may be applied adjacent to the semiconductor layer but not proximal to the substrate. Advantageously ion implantation can be applied in precise patterns laterally and vertically through the layer.

The step to porosify the epitaxial layer may further comprise porosifying at least an upper part of the substrate, wherein the upper part of the substrate has the first resistivity. Advantageously the epitaxial layer may be thinner because part of the porous layer is formed in the substrate instead of the epitaxial layer, which is quicker and therefore cheaper to grow. Advantageously the final substrate, and layered structure, is thinner which may simplify fabrication and thus reduce cost. The resistivity of the upper part of the substrate may be set by doping or ion implantation. All of the substrate may have the same resistivity or only the upper part have the first resistivity.

The method may further comprise a step to provide a source, a drain and a gate over the semiconductor layer to form a switch, wherein the semiconductor layer forms a channel layer. The method may further comprise a step to provide a source, a drain and a gate over the semiconductor layer to form a radio frequency switch, wherein the semiconductor layer forms a channel layer. The switch may be suitable to operate at frequencies of 800MHz to 6GHz or higher. The source and drain may be provided by diffusing or ion implanting a region into the top of the channel layer using a mask. Advantageously the channel layer is a high quality, low defect epitaxial layer and is therefore suitable for high frequency operation. Advantageously the porosity of the porous layer proximal to the substrate is a good insulator between the channel and substrate. Advantageously at least some of the porous layer is a good thermal conductor.

The present invention will be more fully described by way of example with reference to the accompanying drawings, in which:
Figure 1 is a schematic cross-section of an RF switch;
Figure 2 is a schematic cross-section of a layered structure according to the present invention;
Figure 3 is a schematic cross-section of a layered structure according to the present invention;
Figure 4 is a schematic cross-section of an RF switch incorporating the layered structure according to the present invention;
Figure 5, Figure 6 and Figure 8 are a set of schematic cross-sections of a method of fabricating a layered structure according to the present invention;
Figure 7 is a schematic cross-section of a porosification tool for use in the method of fabricating a layered structure according to the present invention;
Figure 9 is a schematic cross-section of a layered structure according to the present invention;
Figure 10 is a schematic cross-section of a first step of a method of fabricating a layered structure according to the present invention;
Figure 11 is a schematic cross-section of a layered structure according to the present invention;
Figure 12 is a plot of the bivariate fit of resistivity against depth through a layered structure according to the present invention.

Epitaxy or epitaxial means crystalline growth of material, usually via high temperature deposition. Epitaxy can be effected in a molecular beam epitaxy (MBE) tool in which layers are grown on a heated substrate in an ultra-high vacuum environment. Elemental sources are heated in a furnace and directed towards the substrate without carrier gases. The elemental constituents react at the substrate surface to create a deposited layer. Each layer is allowed to reach its lowest energy state before the next layer is grown so that bonds are formed between the layers. Epitaxy can also be performed in a metal-organic vapour phase epitaxy (MOVPE) tool, also known as a metal-organic chemical vapour deposition (MOCVD) tool. Compound metal-organic and hydride sources are flowed over a heated surface using a carrier gas, typically hydrogen. Epitaxial deposition occurs at much higher pressure than in an MBE tool. The compound constituents are cracked in the gas phase and then reacted at the surface to grow layers of desired composition.

Deposition means the depositing of a layer on another layer or substrate. It encompasses epitaxy, chemical vapour deposition (CVD), powder bed deposition and other known techniques to deposit material in a layer.

A compound material comprising one or more materials from group III of the periodic table with one or more materials from group V is known as a III-V material. The compounds have a 1:1 combination of group III and group V regardless of the number of elements from each group. Subscripts in chemical symbols of compounds refer to the proportion of that element within that group. Thus Al_{0.25}GaAs means the group III part comprises 25% Al, and thus 75% Ga, whilst the group V part comprises 100% As.

Crystalline means a material or layer with a single crystal orientation. In epitaxial growth or deposition subsequent layers with the same or similar lattice constant follow the registry of the previous crystalline layer and therefore grow with the same crystal orientation. In-plane is used herein to mean parallel to the surface of the substrate; out-of-plane is used to mean perpendicular to the surface of the substrate.

Throughout this disclosure, as will be understood by the skilled reader, crystal orientation <100> means the face of a cubic crystal structure and encompasses [100], [010] and [001] orientations using the Miller indices. Similarly <0001> encompasses [0001] and [000-1] except if the material polarity is critical. Integer multiples of any one or more of the indices are equivalent to the unitary version of the index. For example, (222) is equivalent to, the same as, (111).

Substrate means a planar wafer on which subsequent layers may be deposited or grown. A substrate may be formed of a single element or a compound material, and may be doped or undoped. For example, common substrates include silicon (Si), gallium arsenide (GaAs), silicon germanium (SiGe), silicon germanium tin (SiGeSn), indium phosphide (InP), and gallium antimonide (GaSb).

A substrate may be on-axis, that is where the growth surface aligns with a crystal plane. For example it has <100> crystal orientation. References herein to a substrate in a given orientation also encompass a substrate which is miscut by up to 20° towards another crystallographic direction, for example a (100) substrate miscut towards the (111) plane.

Vertical or out of plane means in the growth direction; lateral or in-plane means parallel to the substrate surface and perpendicular to the growth direction.

Doping means that a layer or material contains a small impurity concentration of another element (dopant) which donates (donor) or extracts (acceptor) charge carriers from the parent material and therefore alters the conductivity. Charge carriers may be electrons or holes. A doped material with extra electrons is called n-type whilst a doped material with extra holes (fewer electrons) is called p-type.

Lattice matched means that two crystalline layers have the same, or similar, lattice spacing and so the second layer will tend to grow isomorphically on the first layer. Lattice constant is the unstrained lattice spacing of the crystalline unit cell. Lattice coincident means that a crystalline layer has a lattice constant which is, or is close to, an integer multiple of the previous layer so that the atoms can be in registry with the previous layer. Lattice mismatch is where the lattice constants of two adjacent layers are neither lattice matched nor lattice coincident. Such mismatch introduces elastic strain into the structure, particularly the second layer, as the second layer adopts the in-plane lattice spacing of the first layer. The strain is compressive where the second layer has a larger lattice constant and tensile where the second layer has a smaller lattice constant.

Where the strain is too great the structure relaxes to minimise energy through defect generation, typically dislocations, known as slip, or additional interstitial bonds, each of which allows the layer to revert towards its lattice constant. The strain may be too great due to a large lattice mismatch or due to an accumulation of small mismatches over many layers. A relaxed layer is known as metamorphic, incoherent, incommensurate or relaxed, which terms are also commonly interchangeable.

A pseudomorphic system is one in which a single-crystal thin layer overlies a single-crystal substrate and where the layer and substrate have similar crystal structures and nearly identical lattice constants. In a pseudomorphic structure the in-plane lattice spacing of the thin layer adopts the in-plane lattice constant of the substrate and is therefore elastically strained, either compressively where the layer has a larger lattice spacing than the substrate or tensilely where the layer has a smaller lattice spacing than the substrate. A pseudomorphic structure is not constrained in the out-of-plane direction and so the lattice spacing of the thin layer in this direction may change to accommodate the strain generated by the mismatch between lattice spacing. The thin layer may alternatively be described as "coherent", "commensurate", "strained" or "unrelaxed", which terms are often used interchangeably. In a pseudomorphic structure all the layers adopt the lattice spacing of the substrate in their respective in-plane lattice spacing.

A layer may be monolithic, that is comprising bulk material throughout. Alternatively it may be porous for some or all of its thickness. A porous layer includes air or vacuum pores, with the porosity defined as the proportion of the area which is occupied by the pores rather than the bulk material. The porosity can vary through the thickness of the layer. For example, the layer may be porous in one or more sublayers. The layer may include an upper portion which is porous with a lower portion that is non-porous. Alternatively the layer may include one or more discrete, non-continuous portions (domains) that are porous with the remainder being non-porous (with bulk material properties). The portions may be non-continuous within the plane of a sublayer and/or through the thickness of the layer (horizontally and/or vertically in the sense of the growth direction). The portions may be distributed in a regular array or irregular pattern across the layer, and/or through it. The porosity may be constant or variable within the porous regions. Where the porosity is variable it may be linearly varied through the thickness, or may be varied according to a different function such as quadratic, logarithmic or a step function.

A porous layer means that pores have been formed through bulk material so that voids are intentionally introduced. Porosity is expressed in percentages which refers to the volume of bulk material which has been removed so 25% porosity means that 25% of the equivalent volume of bulk material is voided.

A fully depleted porous layer means a layer in which there are no charge carriers.

A crystalline bixbyite oxide layer may be a rare earth oxide layer. The rare earth elements are scandium (Sc), yttrium (Y) and all of the lanthanoid series which is lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu). The bixbyite oxides are bixbyite in crystal structure. Other bixbyite oxides include indium oxide (In₂O₃), vanadium oxide (V₂O₅), iron oxide (Fe₂O₃), manganese oxide (Mn₂O₃) and ternary compounds of a rare earth, a metal and oxygen (RE-M-O).

Where a device is described it should be understood that it will typically be formed on a circular substrate wafer of 4" (100mm), 6" (150mm), 8" (200mm), 12" (300mm) or greater diameter. After growth, deposition, bonding and other fabrication steps the devices are separated by dicing the wafer and layers into devices (components or chips) of appropriate dimensions. Typically tens, hundreds or thousands of devices are cut from a single wafer.

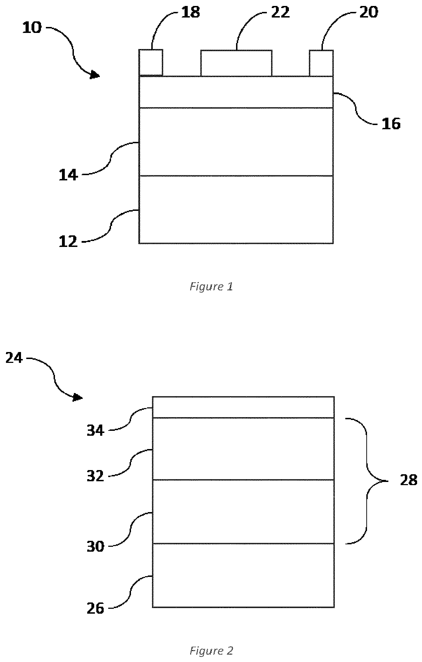

Figure 1 illustrates a radio frequency (RF) switch 10, such as a metal oxide semiconductor field effect transistor (MOSFET). The switch 10 is typically implemented wholly in silicon; that is each layer comprises silicon which may be doped and/or compounded, for example as silicon oxide. A substrate 12 is provided on or over which is provided an insulator 14. On or over the insulator 14 is a channel 16. A source 18, a drain 20 and a gate 22 are provided on the channel 16. When a voltage is applied between the source 18 and drain 20 it causes a current to flow through the channel 16 from the source 18 to the drain 20. The magnitude of the current is modulated by applying a voltage to the gate 22. The insulator 14 acts to insulate the substrate 12 from the channel 16 so that no parasitic current is generated in the substrate 12 or insulator 14. This is important as parasitic currents result in less efficient switching. For 5G wireless transmission of radio frequencies (up to 300GHz, for example), switch operating speeds in this same frequency range are required.

For example, the insulator 14 may comprise a thick polycrystalline silicon layer with a buried oxide layer, e.g. silicon dioxide (SiO₂), over it. In combination with a high resistivity substrate 12, for example with resistivity greater than 3000Ωcm, this insulator 14 separates the harmonic performance of the channel 16 from the substrate 12. One disadvantage of a buried oxide is that the resistivity is limited and the permittivity is relatively high meaning that there can be cross-talk between proximal devices. One disadvantage of a polycrystalline silicon and buried oxide insulator 14 is that a complex multi-step fabrication process is required to form the device since a crystalline silicon channel 16 cannot be grown over polycrystalline or amorphous structures. A further disadvantage is that a high resistivity substrate 12 is required which is expensive and may be difficult to process in some fabrication environments.

The invention will now be described more particularly with reference to Figure 2. A layered structure 24 comprises a substrate 26. The substrate 26 may be a silicon (Si) substrate 26. For example the substrate 26 may comprise silicon <100> as is commonly used for silicon semiconductor applications such as CMOS. Alternatively the substrate 26 may comprise silicon in a different crystal orientation, such as <111> which is preferred for some applications incorporating III-N growth over the silicon. Alternatively the substrate 26 may comprise silicon <110>, or silicon <100> miscut towards another crystal orientation, or silicon <111> miscut towards another crystal orientation.

The substrate 26 may be p-type or n-type by appropriate doping. A p-doped Si substrate 26 that is heavily doped, for example with 5e¹⁸ - 1e¹⁹cm⁻³ dopant impurity concentration, may be referred to as a p' substrate 26 whereas a lightly doped Si substrate 26, for example with less than or equal to 5e¹⁵cm⁻³ carriers, may be referred to as a p⁻ substrate 26. A p' substrate 26 that is doped at 5e¹⁸-1e¹⁹cm⁻³ has a resistivity around 0.01Ωcm to 0.02Ωcm.

Grown on or over the substrate 26 is an insulator 28. The insulator 28 comprises porous silicon which is formed from epitaxially grown silicon as will be described. The insulator 28 may comprise two sublayers 30, 32 with different porosities. The first sublayer 30, which is directly on or over the substrate 26, comprises a higher porosity, for example 30-60%, 30-40% or 35-40%, than the second sublayer 32 which is grown on or over it and which has a porosity less than 25%. The insulator 28 also has a high resistivity, for example greater than or equal to 3000Ωcm. The higher porosity first sublayer 30 has a higher resistivity than the lower porosity second sublayer 32. For example the first sublayer 30 may have a resistivity of 10,000Ωcm, 25,000Ωcm or even higher.

The porous Si having two different porosities means that it combines different beneficial properties. The higher porosity first sublayer 30 is an excellent insulator because the porosification process depletes most or all of the carriers so that it becomes non-conductive, that is not electrically conductive. The lower porosity second sublayer 32 retains the crystalline structure of the epitaxial layer from which it is formed and therefore subsequent layers can be grown epitaxially with very low defect generation or propagation. The second sublayer 32 also has the required thermal properties since it has a higher proportion of the original epitaxial material which has significantly higher thermal conductivity as compared to the porous voids. By appropriate design of the first sublayer 30 and second sublayer 32, the insulator 28 may have thermal conductivity of 3Wm⁻¹K⁻¹ or greater, of 5Wm⁻¹K⁻¹ or greater, of 10Wm⁻¹K⁻¹ or greater, or of another value.

The porous Si insulator 28 may be several microns thick. For example it may be 3µm thick, 4µm thick, 5µm thick, 10µm thick, 20µm thick or another thickness. The thickness of the first sublayer 30 and the second sublayer 32 can be selected so that the desired properties are present. Thus the first sublayer 30 may be thick enough to insulate fully and the second sublayer 32 can be thick enough to provide the thermal conductivity and crystalline structure for subsequent growth.

On or over the insulator 28 is a semiconductor layer 34. The semiconductor layer 34 comprises epitaxially grown silicon, for example 50-1000nm, or more narrowly, 50-500nm, 50-200nm, 50-75nm, 50-150 nm, 100-250nm, 150-500nm or 500-1000nm of silicon. The thickness is set by the desired performance of a device fabricated in, over or from the semiconductor layer 34 but the trend is for the semiconductor layer 34 to need to be thinner relative to the previous generation of devices. The semiconductor layer 34 has a low RMS surface roughness, for example less than or equal to 1nm. The semiconductor layer 34 also has a resistivity greater than a threshold value in order to exhibit appropriate transport properties for the device grown over the layered structure 24. For example the resistivity threshold value may be 10Ωcm, 5Ωcm, 20Ωcm or another value suitable for the specific application contemplated.

The semiconductor layer 34 is high quality, low defect, silicon because it is epitaxially grown. It is therefore particularly suitable to be a channel layer for an RF switch operating at very high speed as it exhibits excellent high frequency performance. The first sublayer 30 of the insulator 28 has a high enough porosity that it is significantly depleted of charge carriers, and may be fully depleted of carriers. It therefore operates as an effective insulator to isolate the channel layer 34 from the substrate 26. This means that there are no parasitic currents which can flow through the insulator 28, particularly the first sublayer 30 of the insulator 28, and that all the current flows through the channel layer 34. This layered structure 24 is characterised by excellent overall harmonic performance. For example, the second harmonic 2F₀ may be less than -100dBm at 15dBm input power, typically measured via a coplanar waveguide structure, which is excellent harmonic performance.

The second sublayer 32 of the insulator 28 has a low enough porosity that the crystalline structure is maintained. This enables the high quality crystalline semiconductor layer 34 to be epitaxially grown over the second sublayer 32. The different levels of porosity in the first and second sublayers 30, 32 may be achieved through the use of different levels of dopant or ion implantation.

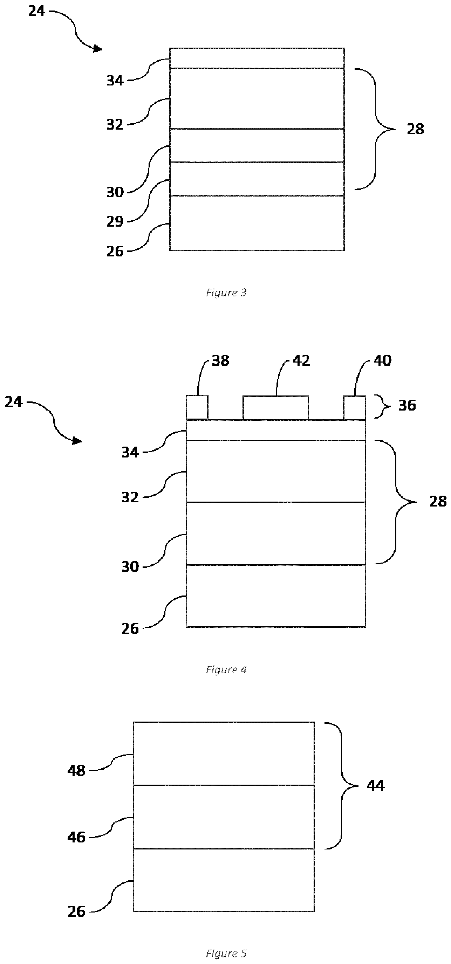

Figure 3 illustrates the layered structure 24 in which part of the insulator 28 comprises epitaxially grown material 29 which has not been porosified. It therefore exhibits the properties of the bulk material, for example good thermal conductivity but relatively poor insulation.

Figure 4 illustrates the layered structure 24 with a device region 36 on, in or over the semiconductor layer 34, in the illustrated example a channel layer. The device region 36 includes a source 38, a drain 40 and a gate 42. As is conventional the source 38 and drain 40 are ion implanted or diffused into the top of the semiconductor (channel) layer 34 to provide ohmic contact to the channel layer 34. The gate 42 is positioned between the source 38 and drain 40 and is on an insulating oxide to enable it to modulate the current flow between the source 38 and drain 40. When a threshold level of voltage is applied between the source 38 and the gate 42 current can flow from the source 38 to the drain 40 whereas when voltage is dropped below the threshold, for example to zero, current is blocked from flowing between the source 38 and drain 40. Thus the current flow is switched on and off by modulating the voltage on the gate 42.

The interface between the semiconductor layer 34 and the insulator 28 is high quality because of the crystallinity of the second sublayer 32 of the porous layer 28. This means that it does not act as a loss mechanism for a switch formed using the layered structure 24. This becomes more important for thinner semiconductor layers 34 for future devices since the interface thickness is a larger proportion of the semiconductor layer thickness and so any losses are proportionately larger.

The thermal characteristics of the layered structure 24 are important because when the switch in the device region 36 is operated it generates heat. If this is not dissipated sufficiently the device heats up during operation and the device characteristics may change. For example the device characteristics may drift out of specification. As switching speed demands increase more heat is generated and so thermal conductivity becomes more important. The porous insulator 28 described addresses this problem by providing the first sublayer 30 which has good harmonic performance whilst also providing the second sublayer 32 which has good crystallinity for subsequent epitaxial overgrowth (i.e. it provides crystal registry) and good thermal conductivity. The first sublayer 30 may also contribute to the thermal conductivity. Furthermore, the harmonic performance of the first sublayer 30 is substantially insensitive to the operating temperature.

The permittivity of the porous insulator 28 is lower than for silicon oxide, a common insulator based on silicon. Advantageously permittivity is responsible for cross-talk between proximal devices in operation and therefore the lower permittivity of the porous insulator 28 reduces cross-talk.

Figure 5 illustrates a first step in a method of fabricating the layered structure 24. In a first step an epitaxial layer 44 is grown on or over the substrate 26. The epitaxial layer 44 may comprise a first sublayer 46 and a second sublayer 48. The first sublayer 46 has a first resistivity R1 and the second sublayer 48 has a second resistivity R2 which is lower than the first resistivity R1. For example, the first resistivity R1 may be in the range 0.4-10Ωcm and the second resistivity R2 may be in the range 0.01-0.4Ωcm. The different resistivities, R1 and R2, may be achieved by doping the first sublayer 46 less than the second sublayer 48 where the dopant is p-type (free carriers are holes not electrons). For example, the first sublayer 46 may be silicon doped with 1e¹⁵ - 5e¹⁶cm⁻³ boron, that is p-doped Si. The second sublayer 48 may be silicon doped with 1e¹⁸ - 1e¹⁹cm⁻³ boron, that is p-doped Si. Alternatively the silicon may be n-doped, for example with 1e¹⁷ - 5e¹⁸cm⁻³ arsenic in the first sublayer 46 and 5e¹⁴ - 1e¹⁶cm⁻³ arsenic in the second sublayer 48.

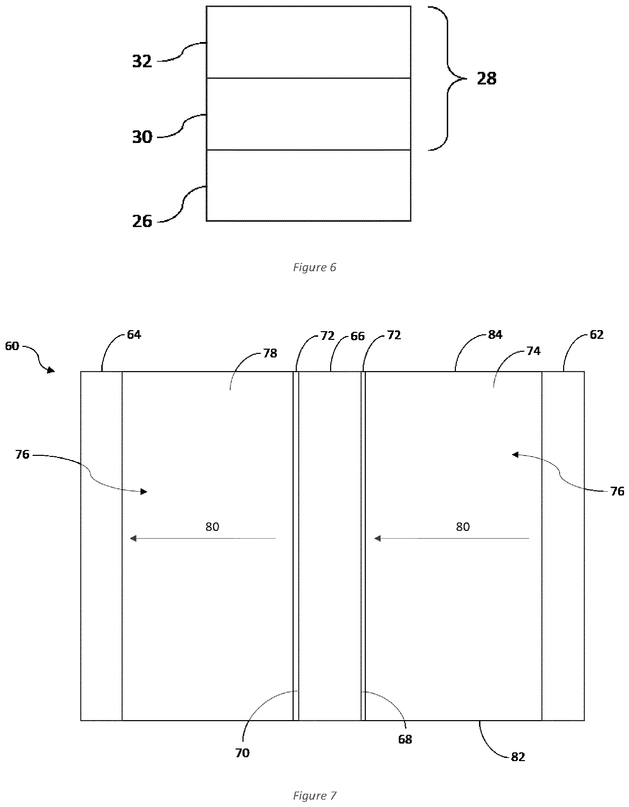

Figure 6 illustrates a second step in the method of fabricating the layered structure 24. In the second step the epitaxial layer 44 is porosified to form porous layer 28. The porous layer 28 has first sublayer 30 and second sublayer 32 which match the first and second sublayers 46, 48 of the epitaxial layer 44. The first sublayer 30 has a higher porosity than the second sublayer 32 because the amount of porosification, for a given porosification process, is dependent on the resistivity of the epitaxial material. Thus the higher resistivity, lower doped first sublayer 46 of the epitaxial layer 44 becomes the more porous first sublayer 30 of the porous layer 28 and the lower resistivity, higher doped second sublayer 48 of the epitaxial layer 44 becomes the less porous second sublayer 32 of the porous layer 28.

Porosifying the epitaxial layer 44 raises the resistivity of the resultant porous insulator 28 to greater than or equal to 3000Ωcm. The first and second sublayers 46, 48 of the epitaxial layer 44 may have resistivities of less than or equal to 10Ωcm, or even less than or equal to 1Ωcm, prior to porosification. For example the first sublayer 46 may have resistivity in the range 0.01-0.4Ωcm and the second sublayer 48 have resistivity in the range 0.4-10Ωcm. The higher the initial resistivity, the higher the final resistivity following porosification with a non-linear relationship therebetween. Thus the first sublayer 30 of the porous layer 28 may have resistivity of greater than or equal to 3000Ωcm and the second sublayer 32 may have resistivity significantly higher than this, for example greater than or equal to 10,000Ωcm.

Alternatively the second step in the method of fabricating the layered structure 24 may comprise porosifying only an upper portion of the epitaxial layer 44 to leave a part adjacent to the substrate 26 which is non-porosified epitaxial material, 29 as illustrated in Figure 3.

More particularly the porosification comprises placing the layered structure 24 of Figure 5 in a porosification tool 60, as will be described with reference to Figure 7. Figure 7 illustrates a conventional tool for porosification of a wafer, for example as described in "Fabrication of p-type porous silicon using double tank electrochemical cell with halogen and LED light sources" by Jongho Park, Yasuko Yanagida and Takeshi Hatsuzawa, http://dx.doi.org/10.1016/i.snb.2016.04.058 0925-4005/© 2016 Elsevier B.V. The porosification tool 60 comprises a cathode 62 and an anode 64 which are spaced apart laterally. Between them is a frame 72 which has the same vertical and horizontal extent as the cathode 62 and anode 64. The frame 72 is configured to support a wafer 66 that is to be porosified. The wafer 66 is typically a circular wafer supported so that its front side 68 faces towards the cathode 62 and its back side 70 faces towards the anode 64. A front side fluid chamber 74 is defined between the cathode 62, the frame 72 and the front side 68 of the wafer 66, when in position, a base plate 82 and a top plate 84. A back side fluid chamber 78 is defined between the anode 64, the frame 72 and the back side 70 of the wafer 66 when in position, the base plate 82 and the top plate 84.

In use the front side fluid chamber 74 and the back side fluid chamber 78 are filled with a fluid 76. The fluid 76 is chosen such that when a voltage is applied between the cathode 62 and anode 64 a current flows through from the cathode 62 to the front side 68 of the wafer 66 and from the back side 70 of the wafer 66 to the anode 64, as shown by the arrows 80. For example, the fluid 76 may be hydrofluoric acid. This current porosifies the front side 68 of the wafer 66 by electrolysis. That is, it etches (tunnels) pores into the surface of the wafer 66 which extend approximately perpendicular to the surface thereby removing material from the wafer 66 in a semi-random pattern. The density of the wafer 66 is therefore reduced.

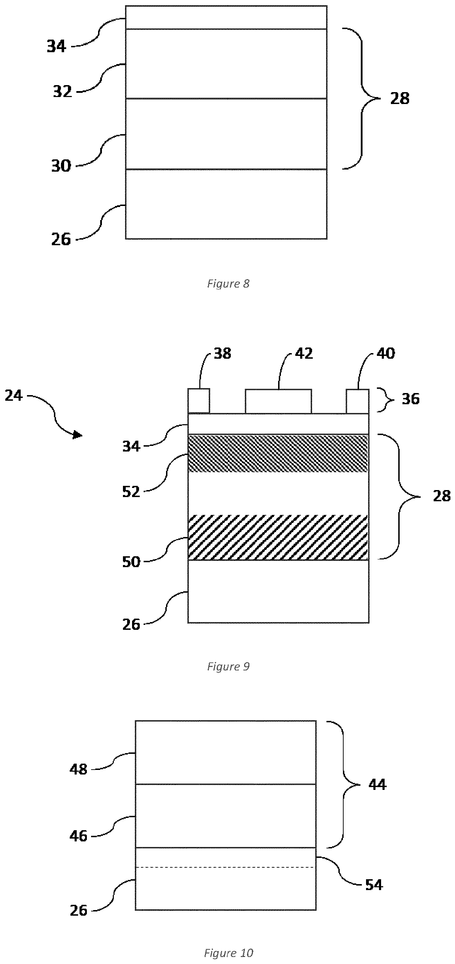

In a third step of the method of fabricating the layered structure 24, illustrated in Figure 8, a semiconductor layer 34 is epitaxially grown over the porous layer 28. The semiconductor layer 34 can be grown epitaxially because the porosity of the second sublayer 32 of the porous layer 28 is sufficiently low that the structure remains crystalline with a single crystal orientation. Thus the semiconductor layer 34 can be grown as a single crystal epitaxial layer with high quality, low defect structure.

Optionally the semiconductor layer 34 is a channel layer and the method includes a further step to grow, deposit or bond the source 38, drain 40 and gate 42 over the channel layer 34 to form the device region 36.

Figure 9 shows the layered structure 24 in which the porous layer 28 comprises a graded porosity through its thickness, with higher porosity in a first portion 50 proximal to the substrate 26 and lower porosity in a second portion 52 adjacent the semiconductor layer 34. For example the porosity in the first portion 50 may be 30-60% and the porosity in the second portion 52 may be less than or equal to 25%. The first portion 50 may be adjacent to the substrate 26 as illustrated or may be spaced therefrom by an epitaxial portion 29. The grading may be linear from adjacent to the substrate 26 to adjacent to the channel layer 34. Alternatively it may follow a different profile, such as quadratic, a higher order polynomial, or logarithmic. Alternatively it may decrease stepwise from adjacent to the substrate 26 up through the porous layer 28. The steps may be of equal size or different sizes. The porosity may decrease by equal amounts or different amounts. The graded porosity is achieved by providing graded doping of the epitaxial layer 44, which in turn causes graded resistivity.

Alternatively the porous layer 28 may comprise more than two sublayers, with an intermediate sublayer or sublayers having greater or lesser porosity than the layers on either side of it. For example, there may be three sublayers with the middle sublayer having higher porosity than either the lower or upper sublayers; or with the middle sublayer having intermediate porosity between the upper and lower sublayers; or with the middle sublayer having lower porosity than the upper or the lower sublayers. Or there could be four sublayers with alternating porosity such that the lowest sublayer has high porosity, for example at least 30%, the next sublayer has lower porosity, for example ≤25%, the next sublayer has the same porosity as the lowest sublayer and the top sublayer has the same porosity as the second sublayer. There could also be a non-porosified sublayer 29 between the lowest sublayer and the substrate 26. Other combinations of sublayers and grading profiles will be apparent to the skilled reader.

The layered structure 24 may be implemented wholly in silicon as described above. Alternatively the insulative porous layer 28 may comprise a different group IV material, such as germanium (Ge), or a compound of silicon with one or more other group IV elements. For example, it may comprise silicon germanium (SiGe) or silicon germanium tin (SiGeSn). If the semiconductor layer 34 is pure silicon there may be a small lattice mismatch between the top of the porous layer 44 and the semiconductor layer 34. This introduces a small amount of strain into the semiconductor layer 34 which may improve carrier transport characteristics, i.e. carrier mobility, relative to an unstrained layer.

Additionally or alternatively the semiconductor layer 34 may comprise another group IV, such as germanium, or a compound of group IV elements such as silicon germanium or silicon germanium tin. As with changing the material of the porous layer 28 this enables a small strain to be introduced to the semiconductor layer 34, by introducing a controlled lattice mismatch, and therefore improves carrier mobility.

Alternatively the semiconductor layer 34 may comprise a compound of a group III and a group V material. For example the semiconductor layer 34 may comprise a III-N material such as gallium nitride (GaN). Such a material may have applications for electronic devices (e.g. a field effect transistor, FET) or photonic devices (e.g. µLEDs). In some applications a GaN semiconductor layer 34 may be grown over a porous layer 28 which is grown over a Si<111> substrate. The semiconductor layer 34 may also comprise a rare earth material in compound with a group III and a group V material. For example it may comprise a rare-earth-III-N compound.

Figure 10 illustrates the first step of the method of fabricating a layered structure 24 in which an upper part 54 of the substrate 26 has the first resistivity R1. Thus it has the same resistivity as the first sublayer 46 of the epitaxial layer 44 which consequently may be thinner. The second sublayer 48 has lower resistivity R2, as described with respect to Figure 5. For example, the first resistivity R1 may be chosen to give porosity greater than 30% whereas the second resistivity R2 may be chosen to give a porosity less than or equal to 25%.

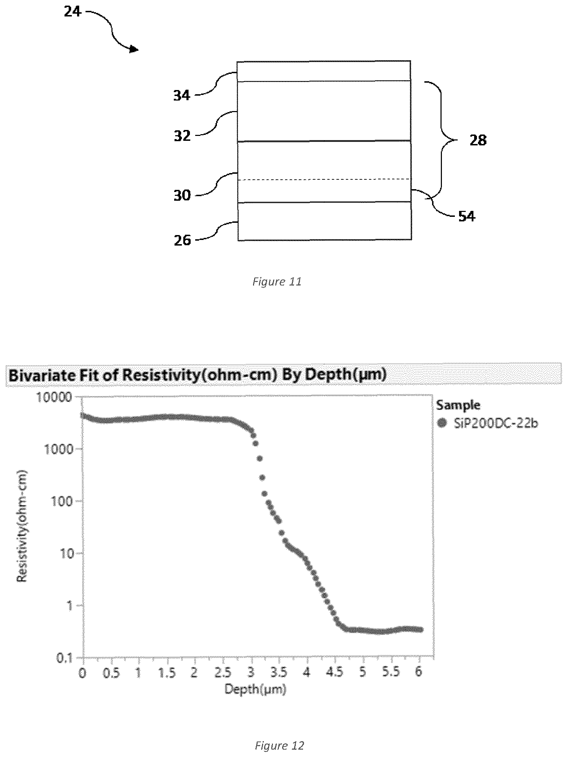

Figure 11 illustrates a layered structure 24 formed from the structure shown in Figure 10. The layered structure 24 comprises a substrate 26 which is thinner than in previous examples. Above the substrate 26 is the porous layer 28 which comprises a first sublayer 30 and a second sublayer 32 as in previous examples. However, in this example the first sublayer 30 is formed by porosifying the upper part 54 of the substrate 26 as well as the first sublayer 46 of the epitaxial layer 44. Since they have the same resistivity R1 to start, porosification forms a single, indistinguishable first sublayer 30 in the porous layer 28. Advantageously the epitaxial layer 44 growth may be quicker in this arrangement because the first sublayer 30 can be thinner since the porous layer 28 is partially formed from the substrate 26. It may be beneficial if the substrate 26 has different resistivities, for example via different levels of doping or ion implantation, in order to provide an etch stop at a defined depth through the substrate 26. Alternatively the substrate 26 may have the same resistivity throughout and the current flow be stopped during porosification when the etch has reached the desired depth into the substrate 26.

Figure 12 is a plot of the bivariate fit of resistivity by depth through the layered structure 24 for an exemplary sample. The sample comprises a first sublayer 30 which is approximately 15µm thick, a second sublayer 32 which is approximately 300nm thick, and a semiconductor layer 34 which is approximately 180nm thick. The resistivity is measured from the top of the layered structure 24 towards and into the substrate 26. As can be seen there is 3µm of high resistivity porous material, with a resistivity around 4kΩcm, corresponding to the first sublayer 30. The second sublayer 32 and semiconductor layer 34 are barely distinguishable on the extreme left of the plot, partly because they are thin relative to the first sublayer 30 and partly because the proximity of the first and second sublayers 30, 32 results in high carrier depletion in the second sublayer 32 as well as the first sublayer 30. The etch is stopped at approximately 4.5µm depth with the remainder of the first sublayer 30 being non-porosified (epitaxial layer 44) with a low resistivity, around 0.3Ωcm. Between these horizontal sections of the plot is an approximately linear transition through the first sublayer 30 of the porous insulator 28 which is the boundary region between the porosified and non-porosified parts of the first sublayer 30. The transition is not abrupt because of the semi-random nature of the porosification pattern. However, the thickness of the layers can be chosen so that the transition does not affect device operation. The substrate 26 is not shown on Figure 12 but would have a resistivity less than 0.1Ωcm.

The insulator 28 has been described with doping of the epitaxial layer 44 during growth in order to achieve the required resistivity. However, ion implantation may be used instead, prior to the porosification of the epitaxial layer 44, to achieve the same levels of resistivity close to the substrate 26 and close to the semiconductor layer 34. For example the epitaxial layer 44 may be doped with the same level of dopant throughout its thickness and then the upper part, adjacent the semiconductor layer 34, be ion implanted to raise the dopant level to give the lower resistivity porous. Alternatively two different amounts of ion implantation can be used distal from and close to the substrate 26, or a graded profile can be used. The ion implantation conductions can be chosen to give a dopant profile that approximately matches those achieved in epitaxial growth.

Although the porous layer 28 has been described as having two sublayers 30, 32 of different porosities, it could instead have three or more sublayers. For example, it could have four sublayers of alternating higher and lower porosity. Such a porous layer 28 can be formed from an epitaxial layer 44 having alternating higher and lower resistivity. Alternatively a first sublayer 30 of the porous layer 28 having higher porosity may be formed from the upper part 54 of the substrate 26 and then a further three sublayers with the lower, higher and lower porosities respectively may be formed from the epitaxial layer 44.

Devices, for example 5G mobile phones, follow a trend of increasing functionality which leads to more stringent requirements on efficiency to minimise signal and power loss with consequential preservation of battery life. Increased functionality also leads to higher frequency which implies a need for improved harmonics and thus a thicker insulator 28 is required to isolate the substrate 26 from the semiconductor layer 34 more effectively. The insulator 28 can be as thick as needed because the porous process is not inherently depth limited but can be controlled by doping level, current density, electrolytic concentration or time. Furthermore, a high quality semiconductor layer 34 can be achieved regardless of the thickness of the insulator 28 because it is dependent on the quality of the epitaxial layer 44 and the preserved crystallinity due to the lower porosity of the second sublayer 32.

By contrast prior methods including a silicon oxide insulator cannot be made thicker because these methods require hydrogen implantation to enable a cleave. If the oxide is too thick, hydrogen implantation to the required depth is not possible. Furthermore, silicon dioxide is a poor thermal conductor and so it cannot be made thicker. Therefore, the prior insulators are not suitable for next generation devices with more stringent harmonic requirements, such as for 5G mobile communications.

## Claims

1. A layered structure (24) comprising:
• a substrate (26);
• a porous layer (28); and
• an epitaxial semiconductor layer (34);
wherein the porous layer (28) has a first porosity greater than 30% proximal to the substrate (26) and a second porosity less than or equal to 25% adjacent to the semiconductor layer (34).

2. A layered structure (24) as claimed in claim 1 wherein the substrate (26) comprises silicon.

3. A layered structure (24) as claimed in claim 1 or claim 2 wherein the substrate (26) has crystal orientation <100>, <111>, <110> or a first crystal orientation miscut towards a second crystal orientation by up to 20°.

4. A layered structure (24) as claimed in any preceding claim wherein the substrate (26) has a resistivity between 0.01Ωcm and 10Ωcm.

5. A layered structure (24) as claimed in any preceding claim wherein the porous layer (28) comprises a group IV material or compound of group IV elements;

6. A layered structure (24) as claimed in any preceding claim wherein the porous layer (28) is doped, and wherein the doping has a graded profile through the porous layer (28) from the substrate (26) to the semiconductor layer (34).

7. A layered structure (24) as claimed in any of claims 1 to 5 wherein the porous layer (28) is doped with a first level of doping adjacent proximal to the substrate (26) and a second level of doping adjacent the semiconductor layer (34).

8. A layered structure (24) as claimed in any preceding claim wherein the porous layer (28) has a resistivity greater than or equal to 3000Ωcm.

9. A layered structure (24) as claimed in any preceding claim wherein the semiconductor layer (34) comprises a group IV material, a compound of group IV elements, a compound of group III and group V elements, or a compound of one or more rare earth elements with group III and group V elements;

10. A layered structure (24) as claimed in any preceding claim wherein the semiconductor layer (34) has an RMS surface roughness of less than 1nm.

11. A layered structure (24) as claimed in any preceding claim wherein the semiconductor layer (34) has a resistivity greater than or equal to 10Ωcm.

12. A layered structure (24) as claimed in any preceding claim wherein the semiconductor layer (34) comprises a channel layer and further comprising a source (38), a drain (40) and a gate (42).

13. A method of fabricating a layered structure (24) comprising steps to:
• grow an epitaxial layer (44) on a substrate (26), wherein the epitaxial layer (44) has a first resistivity (R1) proximal to the substrate (26) and a second resistivity (R2) distal from the substrate (26), and wherein the second resistivity (R2) is less than the first resistivity (R1);
• porosify the epitaxial layer (44) to form a porous layer (28) with porosity greater than 30% proximal to the substrate (26) and porosity less than or equal to 25% distal from the substrate (26); and
• epitaxially grow a semiconductor layer (34) over the porous layer (28).

14. A method as claimed in claim 13 further comprising doping the epitaxial layer (44) during the step to grow the epitaxial layer (44).

15. A method as claimed in claim 14 wherein the doping comprises doping the epitaxial layer (44) with a lower level of dopant proximal to the substrate (26) than adjacent to the channel layer (34).

16. A method as claimed in any of claims 13 to 15 further comprising a step to ion implant at least part of the epitaxial layer (44) prior to the step to porosify the epitaxial layer (44).

17. A method as claimed in any of claims 13 to 16 wherein the step to porosify the epitaxial layer (44) further comprises porosifying at least an upper part (54) of the substrate (26), wherein the upper part of the substrate (26) has the first resistivity (R1).

18. A method as claimed in any of claims 13 to 17 further comprising a step to provide a source (28), drain (40) and gate (42) over the semiconductor layer (34) to form a switch, wherein the semiconductor layer (34) forms a channel layer (34).
